# EUROPEAN PATENT APPLICATION

(11) **EP 2 826 893 A1**
(43) Date of publication of application: **21.01.2015**
(21) Application number: 12871244.5
(22) Date of filing: 22.05.2012
(51) Int. Cl.: C30B 29/38, H01L 21/20

(54) **COMPOSITE SUBSTRATE USED FOR GAN GROWTH**

(30) Priority: 14.03.2012 CN 201210068026
(71) Applicant: Sino Nitride Semiconductor Co, Ltd, Guangdong 523500 (CN)
(72) Inventor: ZHANG, Guoyi, Beijing 100871 (CN); SUN, Yongjian, Beijing 100871 (CN); TONG, Yuzhen, Beijing 100871 (CN)
(74) Representative: Bohnenberger, Johannes
(86) International application number: PCT/CN2012/075853
(87) International publication number: WO 2013/135001

(57) **Abstract**

The present application discloses a composite substrate used for GaN growth, comprising a thermally and electrically conductive layer (1) with a melting point greater than 1000°C and a GaN mono-crystalline layer (2) bcated on the thermally and electrically conductive layer (1). The thermally and electrically conductive layer (1) and the GaN mono-crystalline layer (2) are bonded through a van der Waals force or a flexible medium layer (3). The composite substrate can further include a reflective layer (4) located inside, in the lower portion, or at a lower surface of the GaN mono-crystalline layer. In the disclosed composite substrate, iso-epitaxy required by GaN epitaxy is provided; crystalline quality is improved; and a vertical structure LED can be directly prepared. Further, a thin GaN mono-crystalline layer greatly reduces cost, which is advantageous in applications.

## Description

### TECHNICAL FIELD

The present invention relates to the technical field of semiconductor optoelectronic device and Metal-organic Chemical Vapor Deposition (MOCVD), especially the substrate used for GaN epitaxial sheet growth.

### BACKGROUND OF THE INVENTION

In recent years, III/V nitride materials, mainly GaN, InGaN, and AlGaN, have received much attention as semiconductor materials. The III/V nitride materials have direct band gaps that can be continuously varied from 1.9 to 6.2 eV, excellent physical and chemical stability, and high saturation electron mobility. They have become the preferred materials for optoelectronic devices such as laser devices and light-emitting diodes.

However, to the present GaN-based semiconductor material device, due to a lack of GaN substrate, the epitaxial films of the GaN-based LED are mainly grown on the substrates such as sapphire substrates, SiC, Si substrate and so on. So far, epitaxial-growth technologies of GaN material series are basically based on highly mismatched hetero-epitaxy technologies. Hetero-epitaxial growth technologies of sapphire substrate is the most widely used and protected. The main problems are that: firstly, the large lattice mismatch and thermal stress between the epitaxially grown GaN and the sapphire substrate can produce high concentration of dislocations of about 10⁹ cm⁻², which seriously degrades the quality of GaN crystal, and reduces illumination efficiency and the lifespan of LED. Secondly, because sapphire is an insulator with an electrical resistivity greater than 10¹¹ Ω cm at room temperature, it is not suitable to be used for forming devices having vertical structures. Sapphire is usually only used to prepare N-type and P-type electrodes on the surface of the epitaxial layer, reducing effective lighting area, increasing the lithography and etching processes during the fabrication of the devices, and reducing the material utilization.Thirdly, sapphire has a poor thermal conductivity of about 0.25 W/cm K at 1000°C, which significantly affects performances of GaN-based devices, especially the large-area and high-power devices in which heat dissipation is required. Fourthly, sapphire has a high hardness and its lattice has a 30 degree angle relative to the lattice of GaN crystal, it is difficult to obtain a cleavage plane of the InGaN epitaxial layer to obtain a cavity surface during the fabrication of GaN-based Laser Diode (LD).

However, to the SiC substrate, it has lattice parameters most close to those of GaN and smaller lattice mismatch, but it also is hetero-epitaxy, also exists misfit dislocations and thermal misfit dislocations. Moreover, SiC is expensive, making it unsuitable for many GaN-based optoelectronic devices (LED) . In recently years, Si has also been studied as a substrate for the epitaxial growth of GaN . However, Si has a lattice mismatch to GaN even larger than sapphire/GaN, and Si has cubic crystalline lattice while GaN has a hexagonal crystalline lattice, which makes it difficult to support epitaxial growth of GaN material. The GaN layer grown on Si substrates faces serious problems such as cracking; the growth thickness usually cannot exceed 4 µm.

Therefore, to crystalline epitaxy, either the theory of epitaxial growth, or the development history of the semiconductor epitaxy technology, has proved that, iso-epitaxy is a optimal selection. Recently, preparation technology of GaN mono-crystalline substrate has been developed, the appearance of GaN mono-crystalline substrate, makes GaN epitaxy return to iso-epitaxy, and improves the quality of epitaxially grown GaN crystal. Moreover, the good thermal conductivity of the GaN crystals allows the formation of vertical structure LED on LED epitaxial sheet grown by GaN substrate epitaxy. The properties of the devices are improved under large current injections. However, the high cost of the GaN mono-crystalline substrate severely restricts its usage in LED devices. While a 2 inch wide high power LED epitaxial sheet is typically less than 100 dollars, the price for a 2 inch wide GaN mono-crystalline substrate can reach 2000 dollars at present.

### SUMMARY OF THE INVENTION

The present invention aims to provide new types of composite substrates for GaN growth, in which the iso-epitaxy required by GaN epitaxy is provided, crystalline quality is improved, and a vertical structure LED may be directly formed, besides, the production cost is reduced, bringing it into practical application.

The disclosed composite substrate includes a thermally and electrically conductive layer and a GaN mono-crystalline layer on the thermally and electrically conductive layer.

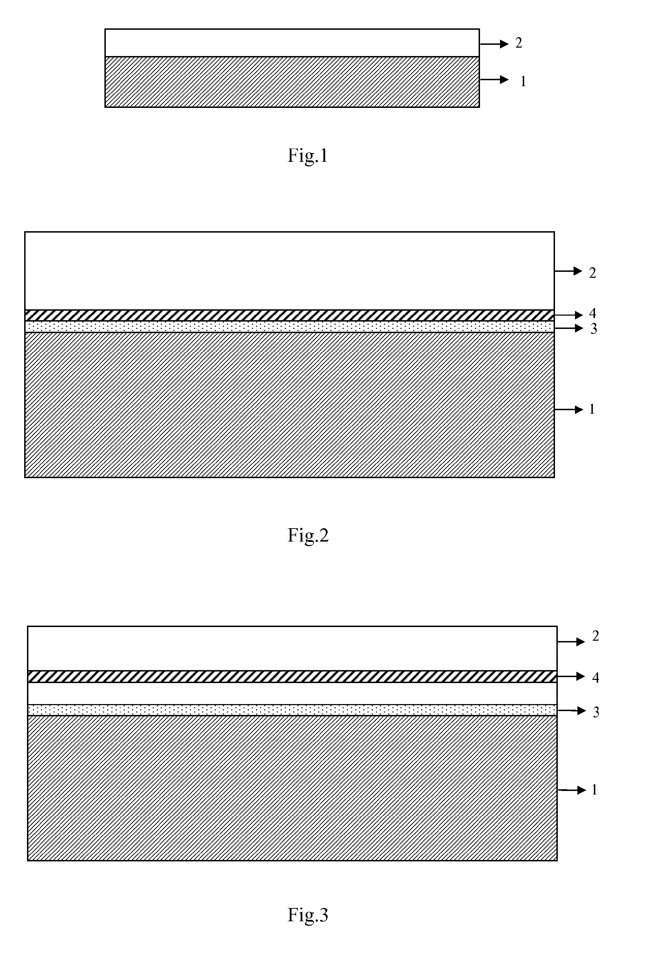

Referring to Figure 1, the composite substrate of the present invention firstly includes a thermally and electrically conductive layer 1, and then a GaN mono-crystalline layer 2 bonded on the thermally and electrically conductive layer.

The thermally and electrically conductive layer has a thickness in range of 10∼ 3000µm, preferably 50∼400µm. Materials suitable for the thermally and electrically conductive layer are required to have several characteristics : (1) a melting point greater than 1000°C, or nearly in solid state under 1000°C;and (2) high thermal and high electrical conductivities.

Based on the above requirements, materials suitable for the thermally and electrically conductive layer can choose from metal elements or alloys or quasi-alloys, such as W, Ni, Mo, Pd, Au, Cr and so on, or alloys of any two or more kinds of the above metals, or alloys of one or more above metals with Cu, such as WCu alloy, MoCu alloy and NiCu alloy and so on. Besides metals, other materials suitable for the thermally and electrically conductive layer can also be Si crystalline, SiC crystalline or AlSi crystalline and so on.

The GaN layer on the thermally and electrically conductive layer has a thickness in a range of 0.1∼100µm, preferably 1∼50µm. The GaN crystal is in the form of a mono crystal.

The thermally and electrically conductive layer can be bonded with the GaN mono-crystalline layer through rigid bonding or flexible bonding. If the bonding is a rigid van der Waals force bonding, the thermal expansion coefficient of the thermally and electrically conductive layer should be close to the thermal expansion coefficient of the GaN mono-crystalline layer, and the "close" here means the difference of the coefficient of thermal expansion is within 10%, and there's no medium between the thermally and electrically conductive materials. And the thermally and electrically conductive layer can also be bonded with GaN layer through a flexible medium. If bonded through a flexible medium, the medium is required to have a melting point greater than 1000°C, and certain ductility, to relax stress, preferably Au-Au bonds with a thickness ranged 0.5∼5µm, or bonds between W, Pd or Ni and other high-temperature metals. The metal medium bonding layer with the said thickness, can relax the thermal mismatch stress produced by different coefficient of thermal expansions between the GaN layer and the thermally and electrically conductive layer, therefore, while bonded with the flexible medium, the thermal expansion coefficient of the thermally and electrically conductive layer is not required to be close to that of GaN.

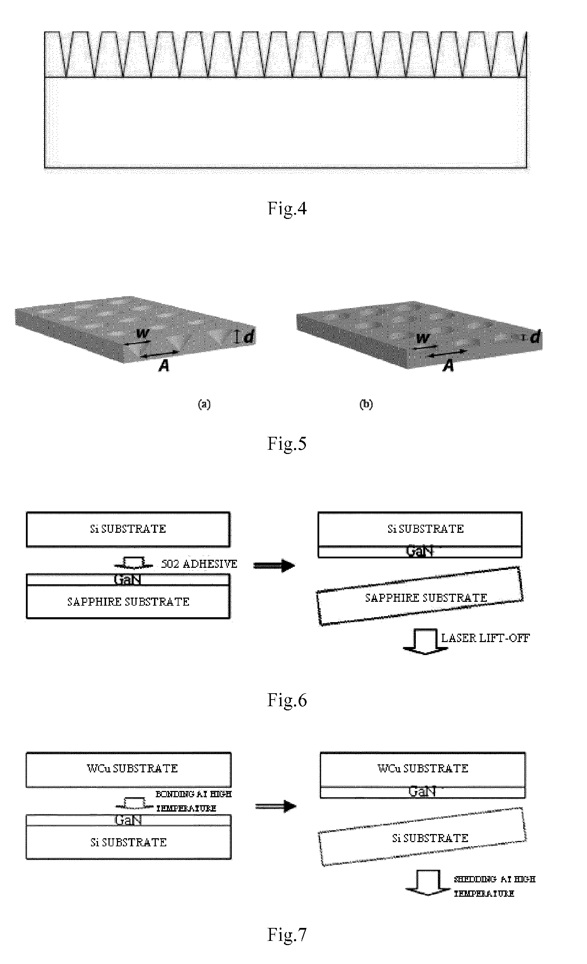

Furthermore, the composite substrate of the present invention can include a reflective layer, located inside, in the lower portion, or a lower surface of the GaN mono-crystalline layer which is the interface of the GaN mono-crystalline layer bonded with the thermally and electrically conductive layer. The reflective layer can be sandwiched at the bonding layer between the thermally and electrically conductive layer and the GaN layer close to GaN layer (that is between the bonding layer and the GaN layer), referring to Figure 2, and it could also be located inside or in the lower portion of the GaN layer, as shown in Figure 3. If the reflective layer is sandwiched at the bonding layer that is close to the GaN layer, the reflective layer can be metallic reflective layer, such as Pd, Cr and so on. If the reflective layer is located inside or in the lower portion of the GaN layer, the reflective layer can be in a periodic or quasi-periodic structure, with grating structures or photonic lattice structures, as shown in Figure 4.

The said grating structures are micron-scale periodic structures, the said photonic lattice structures are nano-scale periodic structures which can be periodic protrusions or recesses. The protrusions and the recesses can have conical shapes, truncated cone shapes, cylindrical shapes, triangular pyramidal shapes, or other shapes. As shown in Figure 5, wherein (a) shows triangular pyramidal recesses distributed periodically, (b) shows cylindrical recesses distributed periodically. These micron-scale or nano-scale periodic structures could be 10nm∼50µm, preferably 200nm∼10µm. In Figure 5, w and d respectively represent the largest width and depth of the recesses, A represents period of structure, wherein A> w.

The micron-scale or nano-scale periodic structures in the reflective layers are usually made of heat-resistant (melting point greater than 1000° C) materials with a refractive index different from that of the GaN, for example, forming periodic structures by materials such as SiO₂, SiN that can grow in a crystalline phase, or coated on or embedded in the GaN mono-crystalline layer. These materials have refractive index different from that of GaN, and generate effective total internal reflections, and the average refractive index at the interface is efficiently increased by the periodic structures.

In some instances, the periodic structures located at the lower portion of the GaN layer are not made of materials different from GaN, but are just periodic patterns formed at the lower portion of the GaN layer, such periodic patterns can also act as reflective layers.

The reflective layer plays a very important role on the GaN-based devices epitaxially grown on the composite substrate of the present invention. Usually, in the light emitting devices epitaxially grown on the substrates, the light from active layer can be emitted in a 360 degree angular range, if there's no design of reflective layer, 40% of the light emitted to the thermally and electrically conductive layer direction from luminescent materials will be absorbed by the substrates and won't be emitted, therefore, the incorporation of the reflective layers to the disclosed composite substrate can thus increase light emission efficiency more than 30%..

The composite substrate of the present invention can be directly used for the epitaxial-growth of GaN epitaxial sheets, and thus the preparation of a vertical structure LED device. The disclosed composite substrate has the one or more following additional advantages compared with conventional technologies:
Firstly, compared with the growth of sapphire substrate in the prior art. Nowadays, sapphire substrate is a substrate that is the most commonly used for growth of GaN epitaxial sheets, because the sapphire substrate has non electro-conductivity and non thermal-conductivity, it's difficult or impossible to grow a vertical structure LED device by the GaN grown on the sapphire substrate, and the planar structure LEDs grown on sapphire substrates the most commonly do not dissipate heat well and are not suitable for high power devices. Additionally, sapphire substrate has a different lattice from that of GaN, which limits the quality of GaN crystals, making it unable to prepare high quality GaN epitaxial sheets.

Compared with the sapphire substrate, the composite substrate of the present invention has very obvious advantages. On one hand, the composite substrate has a GaN layer that enables iso-epitaxial growth of GaN epitaxial sheets on the composite substrate, with improved crystalline quality of growing GaN epitaxial sheets, and thus increased quantum efficiency. On the other hand, there is a thermally and electrically conductive layer in the composite substrate, which allows a vertical structure LED device to be directly prepared by GaN epitaxial sheets grown on the composite substrate according to traditional chip technology, without the limit of the non electro-conductivity and non thermal-conductivity of the substrate, which greatly increases device efficiency.

Secondly, compared to the growth of Si substrate and SiC substrate in the prior art. Although a vertical structure LED may be directly prepared by GaN epitaxial sheets grown on this two kinds of substrates, because of their electro-conductivity and thermal-conductivity, both of them are hetero-epitaxy, which are not good for improving the crystalline quality of GaN. Especially for the Si substrate, AlGaN layers need to be inserted between epitaxy grown GaN crystal on it to relax stress, and the GaN crystal can hardly grow thicker than 3-4 µm on Silicon substrate. Although the lattice constant of a SiC substrate is close to that of a GaN crystal, it is difficult to prepare SiC crystals, and costs are high, which makes it's difficult to be widely applied in GaN-based high power LED devices. Compared with the two kinds of substrates, the main advantages of the composite substrate of the present invention are that, the composite substrate enables iso-epitaxial growth, which can greatly improve the crystalline quality of GaN epitaxial sheets, and makes it suitable for a wide range of applications.

Lastly, compared with GaN mono-crystalline substrate, GaN mono-crystalline substrate which is iso-epitaxial substrate and the composite substrate of the present invention provide iso-epitaxy growth, and the crystalline quality are greatly improved by employing the epitaxial growth of the two kinds of substrates. However, compared with the high cost of the GaN mono-crystalline substrate, the composite substrate of the present invention employs thermally and electrically conductive materials of raw materials cost lower, and GaN layer whose thickness is only one in four hundred to one quarter of the GaN mono-crystalline substrates, the price of which is far lower than GaN mono-crystalline substrates, so there is a more wider application aspect.

In a word, in the composite substrate of the present invention, iso-epitaxy required by GaN epitaxy is provided, crystalline quality is improved, and a vertical structure LED may be directly prepared. Further, a thin-layer GaN mono-crystalline is used, so the cost is greatly reduced, bringing great advantages in application.

### Description of the drawings

Figure 1 is a basic schematic diagram of the composite substrate used for GaN growth of the present invention.
Figure 2 is a schematic diagram of the composite substrate in which a reflective layer is located at the side close to the GaN layer of the bonding layer of the composite substrate.
Figure 3 is a schematic diagram of the composite substrate in which a reflective layer is located inside of the GaN layer of the composite substrate.
Figure 4 is a schematic diagram of a periodic grating or a periodic photonic lattice structure of the reflective layer.
Figure 5 is a schematic diagram of the reflective layer having triangular pyramidal recess (a) or cylindrical recess (b) shaped periodic structures.
Figure 6 is a schematic diagram showing the steps of bonding the Si substrate with 502 adhesive and lifting off the sapphire substrate by laser in the second step as described in Embodiment 1.
Figure 7 is a schematic diagram showing the steps of bonding at high temperature and shedding Si substrate at high temperature in the third step as described in Embodiment 1.

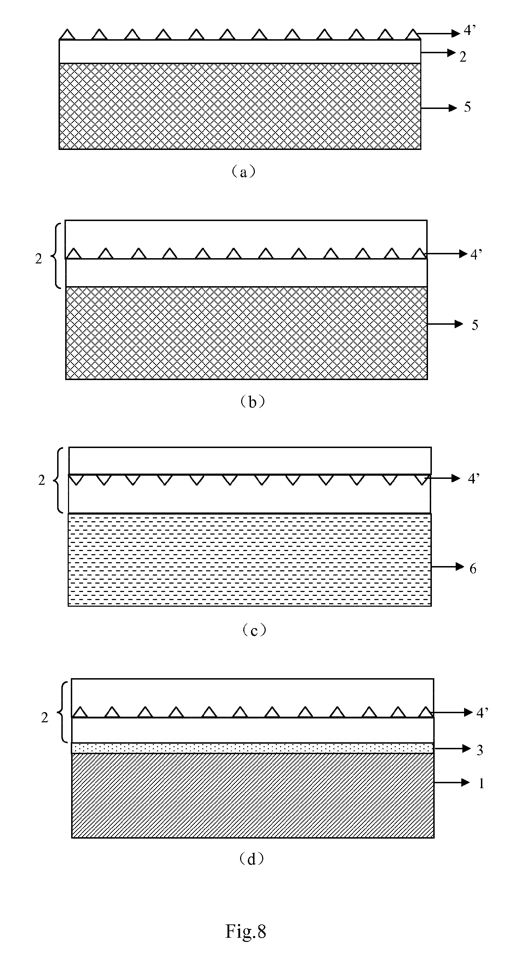

Figure 8 is a flowchart showing the preparation of GaN/WCu composite substrate in which there's a reflective layer in the GaN layer as described in Embodiment 2, wherein: (a) is a schematic diagram showing the preparation of SiO₂ periodic reflective layer on the GaN surface of 4µm GaN/sapphire substrate in the second step; (b) is a schematic diagram showing growing GaN continuously by HVPE Technology until the thickness of GaN reaches to 10µm after the reflective layer is prepared in the third step; (c) is a schematic diagram showing the GaN layer with a reflective layer located on the Si substrate obtained after manufacture in the fourth step; (d) is a schematic diagram showing GaN/WCu composite substrate obtained finally.
Figure 9 is a flowchart showing the preparation of GaN/MoCu composite substrate in which there's a metal reflective layer as described in Embodiment 4, wherein: (a) is a schematic diagram showing the structure obtained by depositing a Pd metal reflective layer on the GaN mono-crystalline layer bonded on the Si substrate in the third step; (b) is a schematic diagram showing obtaining GaN/MoCu composite substrate with a Pd metal reflective layer by Ni-Ni bonds.

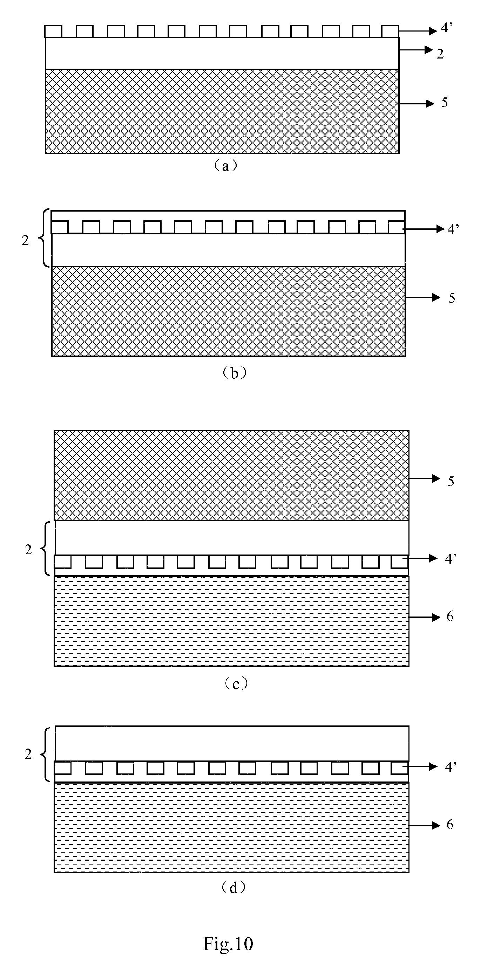

Figure 10 is a flowchart showing the preparation of composite substrate in which the GaN layer is bonded with Si substrate by a van der Waals force as described in Embodiment 5, wherein: (a) is a schematic diagram showing the preparation of SiO₂ cylindrical periodic structures on the GaN surface of GaN/sapphire substrate in the third step; (b) is a schematic diagram showing growing GaN continuously by HVPE technology until the thickness of GaN reaches to 50 µm after the reflective layer is prepared in the fourth step; (c) is a schematic diagram showing the formation of sapphire substrate/GaN/Si structure by a van der Waals force in the fifth step; (d) is a schematic diagram showing the GaN/Si composite substrate obtained by laser lift-off.

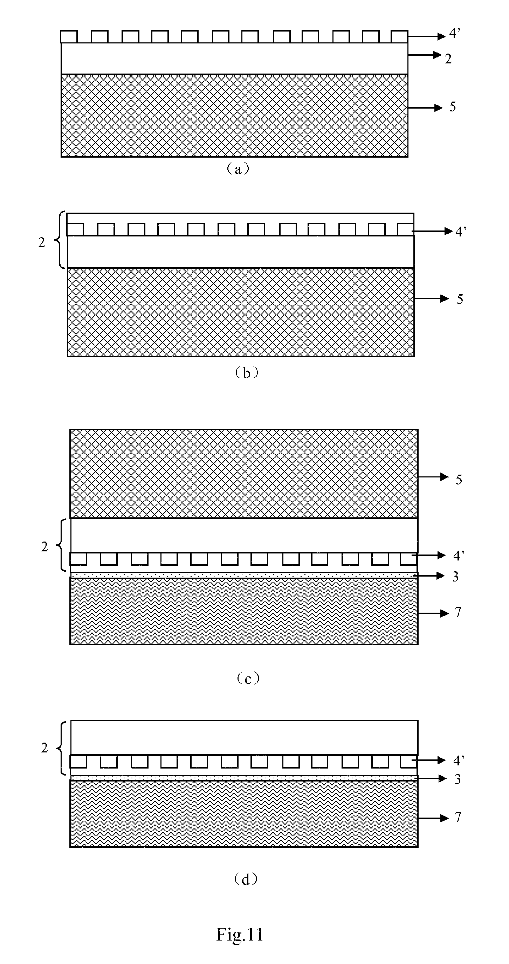

Figure 11 is a flowchart showing the preparation of composite substrate in which the GaN layer and a AlSi substrate is bonded with Au-Au bonds as described in Embodiment 7, wherein: (a) is a schematic diagram showing the preparation of SiO₂ cylindrical periodic structures on the GaN surface of GaN/sapphire substrate in the third step; (b) is a schematic diagram of growing GaN continuously by HVPE Technology until the thickness of GaN reaches to 10µm after the reflective layer is prepared in the fourth step; (c) is a schematic diagram showing the formation of sapphire substrate/GaN/AlSi structure by Au-Au bonds in the fifth step; (d) is a schematic diagram showing the GaN/AlSi composite substrate obtained by laser lift-off in the sixth step.

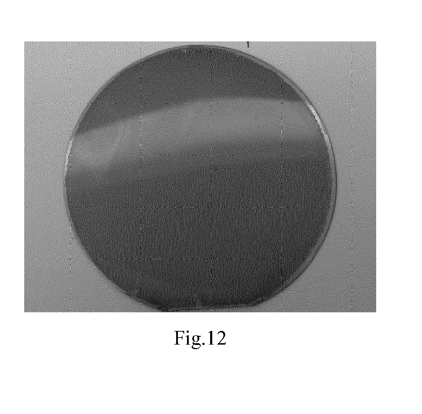

Figure 12 is a photograph of the composite substrate prepared by the present invention in which the GaN mono-crystalline layer is bonded with a metal substrate.

In the figure:

1-the thermally and electrically conductive layer, 2-the GaN layer, 3-the bonding layer, 4-the reflective layer, 4'-the graphical structures of reflective layer, 5 -the sapphire substrate, 6-the Si substrate, 7-the AlSi mono-crystalline substrate.

### Detailed description of the invention

Next, with reference to the drawings, the present invention will be illustrated in detail through the embodiments, but this is not to limit the invention, those skilled in the art could make various amendments or improvements according to the basic thought of the invention, it belongs to the scope of the present invention overall, if not depart from the basic thought of the invention.

### Embodiment 1: A metal composite substrate without reflective layer comprising a WCu metal substrate and a GaN layer bonded with Au-Au bonds

In the first steps, first a 4 µm thick GaN mono crystal epitaxial sheet is grown on a 2 inch 430 µm thick panel sapphire substrate using Metal-organic Chemical Vapor Deposition (MOCVD) well-known in the art, and then a GaN crystal is grown to a crystal thickness of 10 µm using hydride vapor phase epitaxy (HVPE) technique well-known in the art.

In the second steps, the GaN surface of the said GaN mono-crystalline that has been grown is bonded to a 2 inch 400 µm thick Si mono-crystalline substrate using 502 instant adhesive, using the Si substrate as a transfer and support substrate, and then the sapphire substrate is lifted off using laser lift-off technology well-known in the art, leaving a GaN mono-crystalline bonded on the Si substrate, as shown in Figure 6.

In the third steps, a 1 µm Au layer is deposited simultaneously on the GaN surface of GaN mono-crystalline on the Si substrate and the surface of WCu alloy substrate, and then they are bonded together at 300°C, under a pressure of 5 tons, for 15 minutes. After bonding, the 502 instant adhesive is carbonized at high temperature, which allows Si substrate to separate from GaN/WCu composite substrate automatically.

At last, a GaN/WCu composite substrate is obtained after surface cleaning, which includes a 150 µm thick WCu alloy metal substrate with a W:Cu mass ratio of 15:85. The WCu alloy metal substrate and a layer of 10 µm thick GaN mono-crystalline are bonded with Au-Au bonds,wherein the bonding layer is 2µm in thickness.

### Embodiment 2: A metal composite substrate comprising a WCu metal substrate and a GaN layer bonded with Au-Au bonds

In the first steps, a 4µm thick GaN monocrystal epitaxial sheet is grown on a 2 inch 430 µm thick panel sapphire substrate using MOCVD technology well-known in the art.

In the second steps, a 1 µm layer of SiO₂ thin film is grown on the surface of the said GaN mono-crystalline that has been grown using plasma enhanced chemical vapor deposition (PECVD) technology, the SiO₂ thin layer is then patterned with lithography and dry etched well-known in the art into periodic conical structures spaced by a period of about 3 µm, with a base diameter of about 2.5µm and a height of about 1µm, as shown in Figure 8 (a) . The GaN surface is exposed in the space between the conical patterns. The periodic structures can be used as a reflective layer.

In the third steps, a GaN crystal layer is continuously grown on the surface of the said GaN mono-crystalline that has been prepared with a reflective layer using HVPE technology well-known in the art, until the thickness of GaN mono-crystalline reaches to 10µm, as shown in figure 8 (b) .

In the fourth steps, the GaN surface of the said GaN mono-crystalline that has been grown is bonded with a 2 inch 400 µm thick Si mono-crystalline substrate by 502 instant adhesive, using Si substrate as a transfer and support substrate, and the sapphire substrate is then lifted off by laser lift-off technology well-known in the art, leaving GaN mono-crystalline bonded on the Si substrate, as shown in figure 8 (c) .

In the fifth steps, a 1 µm Au layer is deposited simultaneously on the GaN surface of GaN mono-crystalline on the Si substrate and the surface of WCu alloy substrate, and then they are bonded together at 300°C, under a pressure of 5 tons, for 15 minutes. After bonding, the 502 instant adhesive is carbonized at high temperature, which allows Si substrate to separate from GaN/WCu composite substrate automatically (refer to figure 7 ).

At last, a composite substrate as shown in figure 8 (d) is obtained after surface cleaning, which includes a 150 µm thick WCu alloy metal substrate 1 with a W:Cu mass ratio of 15:85. The WCu alloy metal substrate and a layer of 10 µm thick GaN mono-crystalline layer 2 are bonded with Au-Au bonds, wherein the bonding layer 3 is 2µm in thickness. A layer of graphical structures of reflective layer 4' is embedded in the GaN layer 2 and is at 4 µm distance from the bonding layer. The patterns are conical SiO₂ graphical layer structures spaced at a 3 µm period, with a height of 1 µm and a bottom diameter of 2.5µm.

### Embodiment 3: A metal composite substrate comprising a MoCu metal substrate and a GaN layer bonded with Au-Au bonds

In the first steps, a 4 µm thick GaN monocrystal epitaxial sheet is grown on a 2 inch 430 µm thick panel sapphire substrate using MOCVD technology well-known in the art.

In the second steps, a layer of 1 µm thick SiO₂ thin film is grown on the surface of the said GaN mono-crystalline that has been grown using PECVD technology, and the SiO₂ thin layer is then patterned with lithography and dry etched well-known in the art into periodic conical structures spaced by a period of 3µm, with a base diameter of 2.5µm, a height of 1µm, as shown in figure 8 (a) . The GaN surface is exposed in the space between the conical patterns. The periodic structures can be used as a reflective layer.

In the third steps, a GaN crystal layer is continuously grown on the surface of the said GaN mono-crystalline with a reflective layer prepared using HVPE technology well-known in the art, until the thickness of GaN mono-crystalline reaches to 10µm, as shown in figure 8 (b) .

In the fourth steps, the GaN surface of the said GaN mono-crystalline that has been grown and a 2 inch 400 µm thick Si mono-crystalline substrate are bonded with 502 instant adhesive, using the Si substrate as a transfer and support substrate, and the sapphire substrate is then lifted off by laser lift-off technology well-known in the art, leaving GaN mono-crystalline bonded on the Si substrate, as shown in figure 8 (c).

In the fifth steps, a 1 µm Au layer is deposited simultaneously on the GaN surface of GaN mono-crystalline on the Si substrate and the surface of MoCu alloy substrate, and then they are bonded together at 300°C, under a pressure of 5 tons, for 15 minutes. After bonding, the 502 instant adhesive is carbonized at high temperature, which allows Si substrate to separate from GaN/MoCu composite substrate automatically.

At last, a GaN/MoCu composite substrate is obtainedafter surface cleaning, which includes a layer of 150 µm thick MoCu alloy metal substrate with a Mo:Cu mass ratio of 20:80. The MoCu alloy metal substrate and a layer of 10 µm thick GaN mono-crystalline are bonded with Au-Au bonds, wherein the bonding layer Au is 2µm in thickness. A layer of graphical structures of reflective layer is embedded in the GaN layer and is at 4 µm distance from the bonding layer. The patterns are conical SiO₂ graphical layer structures spaced at a 3 µm period, with a base diameter of about 2.5µm and a height about 1 µm.

### Embodiment 4: A metal composite substrate comprising a MoCu metal substrate and a GaN layer bonded with Ni-Ni bonds

In the first steps, a 4 µm thick GaN monocrystal epitaxial sheet is grown on a 2 inch 430 µm thick panel sapphire substrate using MOCVD technology well-known in the art.

In the second steps, the GaN surface of the said GaN mono-crystalline that has been grown and a 2 inch 400 µm thick Si mono-crystalline substrate are bonded with 502 instant adhesive, using the Si substrate as a transfer and support substrate, and the sapphire substrate is then lifted off by laser lift-off technology well-known in the art, leaving GaN mono-crystalline bonded on the Si substrate.

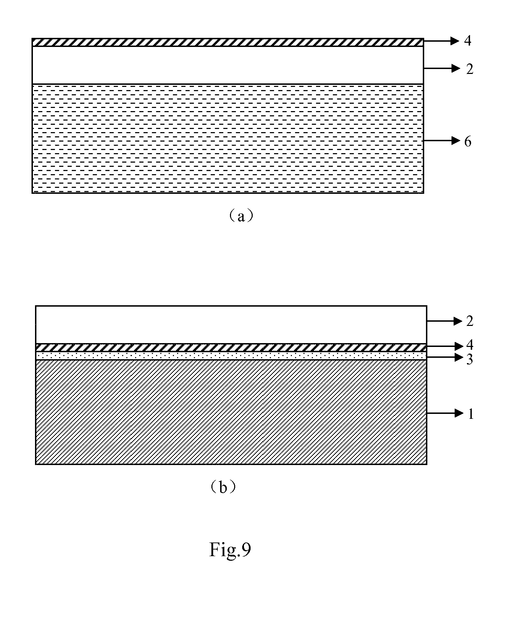

In the third steps, a reflective layer 4 is formed by depositing a 200 nm Pd metal layer on the surface of the GaN mono-crystalline layer 2 on the Si substrate 6, as shown in Figure 9 (a) .

In the fourth steps, a 2µm Ni is deposited simultaneously on the reflective layer of GaN mono-crystalline on the Si substrate that has deposited the reflective layer and the surface of MoCu alloy substrate, and then they are bonded together at 800°C, under a pressure of 15 tons, for 15 minutes. After bonding, the 502 instant adhesive is carbonized at high temperature, which allows Si substrate to separate from GaN/MoCu composite substrate automatically.

At last, a composite substrate as shown in 9 (b) is obtained after surface cleaning, which includes a layer of 150 µm thick MoCu alloy metal substrate 1 with a Mo:Cu mass ratio of 20:80. The MoCu alloy metal substrate 1 and a layer of 4 µm thick GaN mono-crystalline 2are bonded with Ni-Ni bonds, wherein the bonding layer 3 is 4µm in thickness. A layer of Pd metal reflective layer 4 is embedded in the GaN layer 2 and is at 4 µm distance from the bonding layer 3.

### Embodiment 5: A composite substrate comprising a Si substrate and a GaN layer bonded by van der Waals force

In the first steps, a 4 µm thick GaN monocrystal epitaxial sheet grown on a 2 inch 430 µm thick panel sapphire substrate using MOCVD technology well-known in the art.

In the second steps, the said GaN mono-crystalline is continuously grown using HVPE technology well-known in the art, until the thickness of GaN mono-crystalline reaches to 46µm.

In the third steps, a layer of 1 µm thick SiO₂ thin film is grown on the surface of the said GaN mono-crystalline that has been grown by PECVD technology, and the SiO₂ thin layer is then patterned with lithography and dry etched well-known in the art into periodic cylindrical structures spaced by a period of about 3 µm, with a base diameter of about 2 µm and a height about 1 µm, as shown in figure 10 (a) . The surface of the GaN crystal layer is exposed in the space between the cylindrical structures. The periodic structure can be used as a reflective layer.

In the fourth steps, the said GaN monocrystalline that has prepared a reflective layer is continuously grown using HVPE technology well-known in the art, until the thickness of GaN monocrystalline reaches to 50µm, as shown in figure 10 (b) .

In the fifth steps, the said GaN monocrystalline prepared with a reflective layer and a 400 µm thick Si sheet are bonded by van der Waals force, at 900°C, under a pressure of 20 tons, for 30 minutes, forming a structure sample like sapphire/GaN/Si, as shown in 10 (c) .

In the sixth steps, the sapphire substrate is then lifted off by laser lift-off technology well-known in the art, leaving the composite substrate with GaN/Si bonded, as shown in figure 10 (d) .

At last, a composite substrate as shown in 10 (d) is obtained after surface cleaning, which includes a layer of 400 µm thick Si monocrystalline substrate 6, bonded with a layer of 50 µm thick GaN monocrystalline 2 through a van der Waals force. A layer of graphical structures of reflective layer 4' is embedded in the GaN layer 2 and is at a 4 µm distance from the bonding layer. The graphical structures of reflective layer 4' are cylindrical SiO₂ structures spaced at a 3 µm period with a base diameter of about 2 µm and a height about 1 µm.

### Embodiment 6: A metal composite substrate comprising a SiC substrate and a GaN layer bonded with Pd-Pd bonds

In the first steps, a 4 µm thick GaN monocrystal epitaxial sheet is grown on a 2 inch 430 µm thick panel sapphire substrate using MOCVD technology well-known in the art.

In the second steps, a layer of 1 µm thick SiO₂ thin film is grown on the surface of the said GaN monocrystalline that has been grown using PECVD technology, and the SiO₂ thin layer is then patterned with lithography and dry etched well-known in the art into periodic conical structures spaced by a period of about 3 µm, with a bottom diameter of 2.5 µm, a height of 1 µm, as shown in figure 8 (a) . The surface of GaN is exposed in the space between the conical structures. The periodic structure can be used as a reflective layer.

In the third steps, the above GaN monocrystalline that has prepared a reflective layer is continuously grown by HVPE technology well-known in the art, until the thickness of GaN monocrystalline reaches to 10µm, as shown in figure 8(b).

In the fourth steps, the GaN surface of the above GaN monocrystalline grown and a 2 inch 400 µm thick Si mono-crystalline substrate are bonded by 502 instant adhesive, using Si substrate as a transfer and support substrate. And the sapphire substrate is then lifted off by laser lift-off technology well-known in the art, leaving GaN mono-crystalline bonded on the Si substrate, as shown in figure 8 (c) .

In the fifth steps, a 1 µm Pd layer is deposited simultaneously on the GaN surface of the GaN mono-crystalline on the Si substrate and the surface of 200 µm thick SiC substrate. And then they are bonded together at 800°C, under a pressure of 8 tons, for 15 minutes. After bonding, the 502 instant adhesive is carbonized at high temperature, which allows Si substrate to separate from GaN/SiC composite substrate automatically.

At last, a composite substrate as shown in 8 (d) is obtained after surface cleaning, which only replaces the WCu alloy metal substrate in Embodiment 2 with a layer of 200 µm thick SiC mono-crystalline substrate which is bonded with a layer of 10 µm thick GaN monocrystalline by Pd-Pd bonds, wherein the bonding layer Pd is 2µm in thickness. A layer of graphical structures of reflective layer is embedded in the GaN layer and is at a 4 µm distance from the bonding layer. The graphical structures of reflective layer are cylindrical SiO₂ graphical layer structures spaced at a 3 µm period with a base diameter of about 2.5 µm and a height about 1 µm.

### Embodiment 7: A composite substrate comprising a AlSi substrate and a GaN layer bonded with Au-Au bonds

In the first steps, a 6µm-thick GaN monocrystal epitaxial sheet is grown on a 2 inch 430 µm thick panel sapphire substrate using MOCVD technology well-known in the art.

In the third steps, a layer of 1 µm thick SiO₂ thin film is continuously grown on the surface of the above GaN mono-crystalline that has been grown by PECVD technology, and the SiO₂ thin layer is then patterned with lithography and dry etched well-known in the art into periodic conical structures spaced by a period of 3µm, with a bottom diameter of 2 µm, a height of 1 µm, as shown in figure 11 (a) . The surface of GaN is exposed in the space between the conical structures. The periodic structure can be used as a reflective layer.

In the fourth steps, the above GaN monocrystalline that has prepared a reflective layer is continuously grown by HVPE technology well-known in the art, until the thickness of GaN monocrystalline reaches to 10µm, as shown in figure 11 (b) .

In the fifth steps, a 1 µm Au layer is deposited simultaneously on the GaN surface of the sapphire substrate/GaN monocrystalline and the surface of 200µm thick AlSi substrate . And then they are bonded together at 300°C, under a pressure of 5 tons, for 15 minutes, as shown in figure 11 (c) .

In the sixth steps, the sapphire substrate is lifted off by laser lift-off technology well-known in the art, leaving a composite substrate structure with GaN/AlSi bonded, as shown in figure 11 (d) .

At last, a composite substrate as shown in figure 11 (d) is obtained after surface cleaning, which includes a layer of 200 µm thick AlSi mono-crystalline substrate 7 with a Al:Si mass ratio of 30:70. The AlSi mono-crystalline substrate 7 is bonded with a layer of 10 µm thick GaN monocrystalline layer 2 by Au-Au bonds, wherein the bonding layer 3 is 4 µm in thickness. A layer of graphical structures of reflective layer 4'is embedded in the GaN layer 2 and is at a 4 µm distance from the bonding layer, the graphical structures of reflective layer 4 are cylindrical SiO₂ structures spaced at a 3 µm period, with a base diameter of about 2 µm and a height about 1 µm.

## Claims

1. A composite substrate used for GaN growth, comprising a thermally and electrically conductive layer and a GaN mono-crystalline layer located on the thermally and electrically conductive layer, wherein the melting point of the said thermally and electrically conductive layer is greater than 1000 °C.

2. The composite substrate of claim 1, is characterized that, the thickness of the said thermally and electrically conductive layer is 10 µm∼3000 µm, preferably 50 µm∼400 µm; the thickness of the said GaN mono-crystalline layer is 0.1 µm∼100 µm, preferably 1 µm∼50 µm.

3. The composite substrate of claim 1, is characterized that, the materials for the said thermally and electrically conductive layer are elementary metals or alloys or quasi-alloys with a melting point greater than 1000°C.

4. The composite substrate of claim 1, is characterized that, the materials of the said thermally and electrically conductive layer choose from one of W, Ni, Mo, Pd, Au and Cr or alloys of more of them, or the alloys of one or more of these metals with Cu, or Si crystalline, SiC crystalline or AlSi crystalline.

5. The composite substrate of claim 1, is characterized that, there is a flexible medium bonding layer between the said thermally and electrically conductive layer and the GaN mono-crystalline layer.

6. The composite substrate of claim 1, is characterized that, the said composite substrate comprises a reflective layer, which is located inside, in the lower portion, or a lower surface of the GaN mono-crystalline layer, the lower surface of the GaN mono-crystalline layer is the interface of the GaN mono-crystalline layer connected with the thermally and electrically conductive layer.

7. The composite substrate of claim 6, is characterized that, there are a bonding layer, a reflective layer and a GaN mono-crystalline layer on the said thermally and electrically conductive layer in order.

8. The composite substrate of claim 7, is characterized that, the said reflective layer is a metal reflective layer.

9. The composite substrate of claim 6, is characterized that, the said reflective layer is a periodic structure layer with grating structures or photonic lattice structures, located inside or in a lower portion of the GaN mono-crystalline layer.

10. The composite substrate of claim 9, is characterized that, the said reflective layer is a periodic structure formed by materials with a refractive index different from that of GaN and a melting point greater than 1000 , embedded in the GaN mono-crystalline layer.

11. The composite substrate of claim 10, is characterized that, the said reflective layer is a periodic structure formed by SiO₂ or SiN, embedded in the GaN mono-crystalline layer.

12. The composite substrate of claim 9, is characterized that, the said reflective layer is a periodic pattern formed in the lower portion of the GaN mono-crystalline layer.
